## Europäisches Patentamt

## European Patent Office

## Office européen des brevets

(11) Veröffentlichungsnummer: **0 007 993**
A1

# EUROPÄISCHE PATENTANMELDUNG

(21) Anmeldenummer: 79102140.5

(22) Anmeldetag: 27.06.79

(51) Int. Cl.³: **H 01 L 21/60,** H 01 L 23/14, H 01 L 23/54

(30) Priorität: 12.07.78 DE 2830689

(71) Anmelder: **SIEMENS AKTIENGESELLSCHAFT Berlin und München, Postfach 261, D-8000 München 22 (DE)**

(43) Veröffentlichungstag der Anmeldung: 20.02.80 Patentblatt 80/4

(72) Erfinder: **Kiemle, Horst, Dr., Ammerseestrasse 29, D-8021 Neuried (DE)**

(84) Benannte Vertragsstaaten: **FR GB NL**

(54) **Leiterplatte zur Halterung und elektrischen Verbindung von Halbleiterchips.**

(57) Die Erfindung betrifft eine Leiterplatte (2) zur mechanischen Halterung und elektrischen Verbindung von gehäuselosen Halbleiterchips (1).

Um eine hohe Packungsdichte zu ermöglichen, wird für das Substrat (2) der Leiterplatte der gleiche Werkstoff gewählt wie für das Substrat (1) der Halbleiterchips. Damit können sehr feine Verdrahtungsstrukturen erreicht und thermische Spannungen vermieden werden.

Die Erfindung läßt sich für logische Komplexe allgemein und für Speicher im besonderen anwenden.

EP 0 007 993 A1

SIEMENS AKTIENGESELLSCHAFT          Unser Zeichen
Berlin und München                 VPA 78 P 2 0 3 6 EUR

### Leiterplatte

Die Erfindung betrifft eine Leiterplatte mit Leitbahnen
zur mechanischen Halterung und elektrischen Verbindung
von gehäuselosen Halbleiterchips nach dem Oberbegriff
des Patentanspruchs 1.

Im Zuge der Großintegration gelingt es, immer mehr elektronische Funktionen auf kleinen Halbleiterchips zu vereinigen
und damit die einzelnen Funktionen immer billiger und mit
höherer Arbeitsgeschwindigkeit zur Verfügung zu stellen. Gewöhnlich werden solche Halbleiterchips in kleine mit Anschlußfahnen versehene Gehäuse eingesetzt. Solche Bausteine
sind zwar leicht zu handhaben, sie benötigen aber beim Einbau
auf Leiterplatten mit geätzten, zumeist in mehreren Leitbahnlagen angeordneten Leiterbahnen viel Platz, gemessen
an der Größe der Halbleiterchips.

Eine größere Packungsdichte läßt sich erreichen, wenn gehäuselose Halbleiterchips auf Leiterplatten mit miniaturisiertem
Verdrahtungsmuster gesetzt werden. Bevorzugt werden dazu
She 1 Fdl/ 11. 7. 1978

in Dickschichttechnik aufgebaute Mehrlagenplatten aus Keramik verwendet, auf die die Halbleiterchips nach einem Verfahren aufgelötet werden, das unter der Bezeichnung Flip-Chip bekannt ist.

Schwierigkeiten ergeben sich daraus, daß zum einen Dickschicht-Leitbahnen nicht beliebig schmal hergestellt werden können, so daß eine genügend dichte Verdrahtung nur durch eine größere Zahl leitender Lagen realisierbar ist. Dies führt häufig zu einer Verwölbung der Leiterplatte. Zum anderen geben die unterschiedlichen Ausdehnungskoeffizienten von Leiterplatte und Halbleiterchips bei Temperaturänderungen Anlaß zu mechanischen Spannungen, die häufig zu Brüchen führen.

Aufgrund der beschränkten Verdrahtungsmöglichkeiten können bisher nur relativ wenige Halbleiterchips auf einer keramischen Leiterplatte vereinigt werden. Die auftretenden thermischen Spannungen lassen nur relativ kleine Halbleiterchips mit wenigen Anschlüssen zu oder zwingen zu einer sehr aufwendigen Anschlußtechnik zwischen Halbleiterchip und Leiterplatte durch Kontaktierung mit feinen Drähten oder Metallbändern.

Der Erfindung liegt die Aufgabe zugrunde, eine Leiterplatte zum direkten Auflöten von Halbleiterchips so auszubilden, daß keine thermischen Spannungen entstehen und eine sehr hohe Verdrahtungsdichte erreichbar ist.

Die Aufgabe der Erfindung wird dadurch gelöst, daß das Substrat der Leiterplatte aus demselben Werkstoff besteht wie das Substrat der Halbleiterchips.

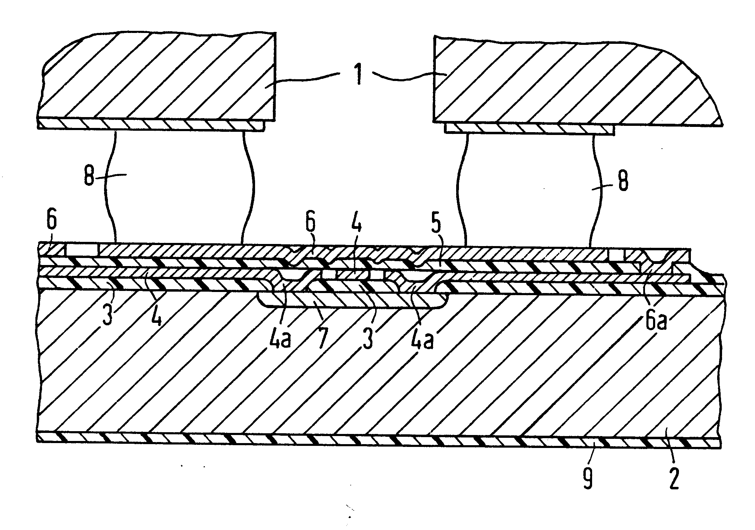

Die Erfindung wird nachstehend anhand eines Ausführungsbeispiels näher beschrieben. Die Zeichnung zeigt einen Teil eines Querschnitts durch die Leiterplatte gemäß

der Erfindung mit andeutungsweise dargestellten Halbleiterchips. Das Ausführungsbeispiel geht davon aus, daß die Halbleiterchips 1 ein Siliziumsubstrat besitzen. Gemäß der Erfindung besteht das Substrat 2 der Leiterplatte ebenfalls aus Silizium. Auf der einen Hauptfläche des Substrats 2, in der gezeichneten Schnittdarstellung auf der oberen Seite, ist zunächst eine Isolierschicht 3 aus Siliziumoxid $Si\,O_2$ oder Siliziumnitrid $Si_3\,N_4$ aufgebracht. Darauf folgt eine erste Leitbahnlage 4 mit Leitbahnen aus Aluminium. Die Leitbahnlage 4 ist durch eine Isolierschicht 5 abgedeckt, auf der sich eine zweite Leitbahnlage 6 befindet. Entsprechend könnten weitere Leitbahnlagen vorgesehen werden.

Eine andere Möglichkeit, zusätzliche Leitbahnen zu erzeugen, besteht in der Herstellung diffundierter Leitbahnen 7. Solche Leitbahnen werden durch Diffusion geeigneter Fremdatome wie Bor, Arsen oder Phosphor in das Siliziumsubstrat hergestellt. Einzelne Leitbahnen verschiedener Leitbahnlagen werden über Durchkontaktierungen 4a bzw. 6a verbunden. Mit Hilfe vorbereiteter Anschlußhöcker 8 werden die Chips mit der Leiterplatte kontaktiert.

Die zur Verdrahtung dienenden Leitbahnen und die dazwischenliegenden isolierenden Schichten werden auf der Grundplatte 2 in an sich bekannter Weise mit denselben Prozess-Schritten aufgebaut wie bei den entsprechenden Halbleiterchips. Mit Hilfe der in der Halbleitertechnik ebenfalls üblichen Fotolitographie lassen sich Leitbahnmuster herstellen, deren Strukturfeinheiten mit denen auf den Chips selbst vorhandenen vergleichbar sind. Damit kann eine hohe Verdrahtungsdichte erreicht werden, so daß eine größere Zahl eng gepackter Chips mit sehr vielen Anschlüssen miteinander verbunden
werden können.

Möglicherweise notwendig werdende nachträgliche Änderungen
der Verdrahtung lassen sich ausführen durch Auftrennen
von Leiterbahnen mittels Laserstrahlen und Legen zusätzlicher Verbindungen durch Bonddrähte. Auch hierbei
können die in der Halbleiterfertigung üblichen Verfahren
und Anlagen eingesetzt werden.

Infolge der dichten Packung von Halbleiterchips auf der
Leiterplatte wird in den meisten Fällen Luftkühlung zur
Abfuhr der Luftwärme nicht ausreichend sein. Die zweite
Hauptfläche des Substrats der Leiterplatte wird dann in
Berührung mit einer wärmeleitenden Platte oder mit einer
Kühlflüssigkeit gebracht. Es ist dann zweckmäßig, diese
Fläche mit einer Passivierungs- oder Isolierschicht 9
zu versehen, um unerwünschte Wechselwirkungen mit dem
Kühlmittel auszuschalten.

Da die Leiterplatte erfindungsgemäß aus dem gleichen
Material besteht wie die Halbleiterchips, lassen sich
bei Bedarf auch aktive Schaltungen, wie beispielsweise
Auswahlschaltungen für Speicher, unmittelbar in die
Leiterplatte integrieren.

Wenn für die Bestückung der Halbleiterplatte integrierte
Schaltungen auf einem Saphir- oder Spinellsubstrat vorgesehen sind, wird das Material für das Substrat der Leiterplatte entsprechend Saphir bzw. Spinell vorgesehen. In
diesen Fällen ist natürlich die Abdeckung der nicht für
die Verdrahtung benützten Hauptfläche unnötig. Im übrigen
geschieht die Herstellung der Leiterplatte auch hierbei
nach der gleichen Methode wie die Herstellung der integrierten Halbleiterchips.

1 Figur

5 Patentansprüche

## Patentansprüche

1. Leiterplatte mit Leitbahnen zur mechanischen Halterung und elektrischen Verbindung von gehäuselosen Halbleiterchips mit integrierten Schaltungen durch unmittelbare Verlötung von Anschlußpunkten auf den Halbleiterchips mit entsprechenden Anschlußpunkten auf der Leiterplatte, d a - d u r c h   g e k e n n z e i c h n e t, daß das Substrat (2) der Leiterplatte aus demselben Werkstoff besteht wie das Substrat (1) der Halbleiterchips.

2. Leiterplatte nach Anspruch 1, d a d u r c h   g e k e n n - z e i c h n e t, daß auf einer Hauptfläche mehrere, durch Isolierschichten (3, 5) getrennte Leitbahnlagen (4, 6) mit metallischen Leitbahnen vorgesehen sind, wobei einzelne Leitbahnen in verschiedenen Leitbahnlagen gegebenenfalls mittels Durchkontaktierungen (4a, 6a) verbunden sind.

3. Leiterplatte nach Anspruch 2, d a d u r c h   g e - k e n n z e i c h n e t, daß zusätzliche Leitbahnen (7) durch partielle Anreicherung mit Fremdatomen in ober- flächennahen Schichten des Leiterplattensubstrats er- zeugt sind.

4. Leiterplatte nach einem der Ansprüche 1 bis 3, d a - d u r c h   g e k e n n z e i c h n e t, daß die zweite Hauptfläche isoliert bzw. passiviert ist und mit einer gut wärmeleitenden Kühlplatte oder mit einer Kühlflüssigkeit in Verbindung steht.

5. Leiterplatte nach einem der vorhergehenden Ansprüche, d a d u r c h   g e k e n n z e i c h n e t, daß zusätzli- che, insbesondere aktive Schaltungsanordnungen integriert sind.

0007993

VPA 78 P 2 0 3 6 EUR

<u>Liste der Bezugszeichen</u>

1   Halbleiterchip
2   Substrat der Leiterplatte
3   erste Isolierschicht
4   erste Leitbahnlage
5   zweite Isolierschicht
6   zweite Leitbahnlage
4a,6a Durchkontaktierung
7   diffundierte Leitbahn
8   Anschlußhöcker
9   Isolierschicht

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | <u>FR - A - 2 292 336</u> (IBM)<br>* Figuren 3,8; Seite 9, Zeile 21 - Seite 10, Zeile 10 *<br>& DE - 2 542 518<br><br>-- | 1,2 |
| X | IBM TECHNICAL DISCLOSURE BULLETIN, Band 15, Juli 1972, New York, US, D.J. BODENDORF et al.: "Active silicon chip carrier", Seiten 656-657<br>* Figur *<br><br>-- | 1,2,5 |
| | <u>FR - A - 2 295 570</u> (IBM)<br>* Figuren 1A,2A; Seite 5, Zeilen 31-40; Seite 7, Zeilen 7-14 *<br>& DE - 2 554 965<br><br>-- | 1,3,5 |
| | <u>FR - A - 2 026 315</u> (TEXAS)<br>* Figur 1; Seite 2, Zeilen 17-21 *<br>& DE - 1 962 003<br><br>-- | 1,4 |
| | <u>DE - A - 1 591 501</u> (SIEMENS)<br>* Figuren 1-4; Seite 8, Absatz 7 *<br><br>---- | 1,3-5 |

**KLASSIFIKATION DER ANMELDUNG (Int.Cl.³)**

H 01 L 21/60
23/14
23/54

**RECHERCHIERTE SACHGEBIETE (Int. Cl.³)**

H 01 L 21/60
23/14

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 24-09-1979 | DE RAEVE |

EPA form 1503.1  06.78